# FASCICULE DE BREVET EUROPEEN

(11) **EP 2 988 004 B1**
(45) Date de publication et mention de la délivrance du brevet: **08.08.2018**
(21) Numéro de dépôt: 15178756.1
(22) Date de dépôt: 29.07.2015
(51) Int. Cl.: F04D 25/06, F04D 29/58, H05K 7/20, B60H 1/00, H02K 11/00

(54) **DISPOSITIF DE COMMANDE POUR MOTEUR ELECTRIQUE DE VENTILATION D'ECHANGEUR**
STEUERVORRICHTUNG FÜR ELEKTROMOTOR MIT WÄRMETAUSCHERBELÜFTUNG
CONTROL DEVICE FOR ELECTRIC MOTOR FOR EXCHANGER VENTILATION

(30) Priorité: 30.07.2014 FR 1457404
(43) Date de publication de la demande: 24.02.2016
(73) Titulaire: G. Cartier Technologies, 74302 Cluses (FR)
(72) Inventeur: BREHERET, Jean-Luc, 74300 Châtillon sur Cluses (FR); PIGNAL-JACQUARD, Marcel, 74890 Bons en Chablais (FR)
(74) Mandataire: Cabinet Poncet

(56) Documents cités:
- WO-A2-03/037664
- DE-A1-102010 043 312
- FR-A1- 2 827 345
- FR-A1- 2 943 864
- FR-A3- 2 676 610

## Description

La présente invention concerne les dispositifs de commande permettant de commander la vitesse de rotation du moteur électrique à courant continu servant à la ventilation des échangeurs et du moteur d'un véhicule automobile, pour leur refroidissement.

L'échangeur thermique associé au refroidissement de l'eau servant au transfert des calories du moteur thermique est généralement couplé, par mise en série, avec l'échangeur servant à l'évacuation des calories issues de la compression du gaz utilisé pour la climatisation. Un ventilateur, entraîné en rotation par un moteur à courant continu, est placé devant ou derrière ces échangeurs afin de générer le flux d'air devant les traverser pour faciliter les échanges thermiques. Ce flux d'air est ensuite dirigé vers le moteur.

Les besoins en débit d'air associés à ce couple « échangeur de refroidissement moteur - échangeur de climatisation » peuvent aller :
- d'une ventilation douce, dans le cas d'une température moteur basse et d'une demande modérée de la climatisation alors que le véhicule est roulant et génère déjà ainsi un flux d'air,
- à une ventilation maximale, dans le cas d'un véhicule à l'arrêt avec moteur en surchauffe après une longue montée avec véhicule chargé, couplé à une forte température externe générant un besoin en climatisation important.

Cette différence de besoins est traitée dans la plupart des cas par des vitesses variables du ventilateur réalisées par un dispositif de commande générant une tension variable sur les bornes d'alimentation du moteur à courant continu.

Un premier type connu de dispositif de commande à tension variable utilise une résistance en série dans le circuit d'alimentation du moteur à courant continu, produisant la réduction du courant et de la tension aux bornes du moteur, pour une rotation à vitesse réduite. Pour produire une rotation à vitesse maximale du moteur, cette résistance est court-circuitée. Ce type de dispositif de commande à résistance série est décrit par exemple dans le document FR 2 826 199 A1.

Un second type connu de dispositif de commande à tension variable utilise un dispositif électronique de découpage de tension à modulation de largeur, généralement désigné par le sigle PWM (pulse width modulation - modulateur de largeur d'impulsion), produisant une tension de sortie qui est tantôt égale à la tension d'entrée pendant des étapes de conduction, tantôt égale à zéro pendant des étapes de non-conduction, et dont on fait varier la valeur moyenne par la modification du rapport des durées des étapes de conduction et des étapes de non-conduction. Ce type de dispositif électronique de commande à modulation de largeur est décrit par exemple dans le document US 6,369,533 B1.

Les constructeurs automobiles recherchent actuellement l'augmentation de la durée de vie des véhicules, la réduction des pertes électriques (réduction de la consommation en carburant ou augmentation de l'autonomie pour les véhicules électriques), ainsi que la modération du coût de production.

La technologie à résistance série, particulièrement performante d'un point de vue économique, peine à rester compatible avec l'augmentation de la durée de vie des véhicules car, presque exclusivement basée sur des relais électromécaniques, son nombre de commutations est limité. Mais son plus gros désavantage réside dans les pertes d'énergie électrique générées par la résistance série. En effet, celles-ci atteignent couramment 50% au point de fonctionnement le plus utilisé.

La technologie à découpage de tension à modulation de largeur PWM semble une solution plus avantageuse, malgré un coût largement supérieur à celui de la technologie à résistance série. Dans ce cas, pour réaliser les étapes de conduction et les étapes de non-conduction, la commutation du courant électrique d'alimentation du moteur à courant continu est assurée par un circuit électronique de puissance comportant des composants électroniques de type transistor à effet de champ à grille isolée (MOSFET), et des diodes de puissance. Pendant leur fonctionnement, ces composants électroniques subissent un échauffement non négligeable, la température de leur jonction pouvant avoisiner les 150°C ou 175°C, sans toutefois que cela ne perturbe leur fonctionnement. La durée de vie de ces composants électroniques est très largement supérieure à celle d'un système à relais.

Cependant, une telle technologie à découpage de tension à modulation de largeur PWM génère des tensions et des courants électriques de forme carrée à variations brusques entre les étapes de conduction et les étapes de non-conduction, ce qui génère simultanément des bruits électromagnétiques, c'est-à-dire des émissions d'ondes électromagnétiques qui polluent l'environnement du dispositif de commande.

Pour réduire suffisamment ces bruits électromagnétiques, le circuit électronique de puissance est associé à un circuit de filtrage apte à transformer les tensions et courants électriques de forme carrée, résultant du découpage, en une tension quasi-continue. Le filtrage permet ainsi la réduction du bruit sonore généré par les spires du moteur, mais aussi, et surtout, la réduction des bruits électromagnétiques.

Un filtrage efficace nécessite d'utiliser des condensateurs électrolytiques, qui permettent de réaliser une très grande capacité, pour un coût et un volume modiques. Pour que leur coût de production soit raisonnable, les condensateurs électrolytiques doivent fonctionner dans des conditions dans lesquelles leur température interne nominale est inférieure à 100°C environ.

Cependant, ces condensateurs électrolytiques sont très sensibles à l'élévation de leur température interne. Une élévation de température interne peut réduire grandement leur durée de vie, se traduisant par une réduction significative de leur valeur de capacité. Ainsi une augmentation de 10°C peut diviser par 2 la durée de vie correspondant à une perte de 20% de la valeur de la capacité.

Or une réduction de capacité engendre une réduction de l'effet de filtrage, et une augmentation de l'ondulation des courants et tensions électriques, ondulation qui elle-même induit un échauffement supplémentaire des condensateurs électrolytiques. Un effet d'avalanche apparaît alors. Il s'en suit, au mieux, une non-conformité vis-à-vis des normes relatives aux émissions parasites d'ondes électromagnétiques, et, au pire, la fin de fonctionnement du dispositif de commande.

Dans les dispositifs de commande à circuit électronique de découpage de tension à modulation de largeur utilisés jusqu'à présent dans les véhicules automobiles, par exemple le dispositif, conforme au préambule de la revendication 1, tel que décrit dans le document FR 2 943 864 A1, le circuit de commutation de puissance à composants électroniques, et le circuit de filtrage à condensateurs électrolytiques, sont logés dans un boîtier commun apte à être fixé aisément à proximité du ventilateur.

Pour éviter un échauffement excessif des condensateurs électrolytiques, les composants électroniques qui génèrent un échauffement conséquent, à savoir les diodes et les transistors à effet de champ à grille isolée, sont montés sur un radiateur métallique, de taille importante, que l'on place dans le flux d'air principal du ventilateur, c'est-à-dire à l'intérieur du diamètre formé par l'hélice du ventilateur. Cela est nécessaire pour maintenir la température interne du boîtier, et les condensateurs électrolytiques, aussi près que possible de la température externe de l'air de ventilation.

On constate couramment que le transistor à effet de champ à grille isolée ou la diode sont doublés, non pas pour permettre d'augmenter la puissance du dispositif de commande, mais simplement pour limiter l'échauffement interne et maintenir la durée de vie du dispositif de commande.

Cependant, la présence et la taille du radiateur, et l'ajout de composants en double, réduisent grandement la performance économique. De plus, la présence et la taille du radiateur présent dans le cercle formé par l'hélice du ventilateur augmentent significativement la perte de charge et donc l'efficacité du système de ventilation.

Un besoin existe donc de concevoir un dispositif de commande de moteur à courant continu de ventilation qui présente à la fois les avantages d'un faible coût de production, d'une faible consommation d'énergie électrique, de faibles émissions électromagnétiques, d'une grande durée de fonctionnement, et d'une faible perturbation du système de ventilation.

La présente invention résulte de l'observation selon laquelle, dans un dispositif de commande à circuit électronique de découpage de tension à modulation de largeur, les composants électroniques du circuit de découpage de puissance pourraient avantageusement fonctionner à des températures relativement élevées, tandis que le circuit de filtrage doit impérativement fonctionner à des températures nettement plus basses. Il y aurait donc un intérêt à ce que les deux types de composants fonctionnent à des températures différentes, proches de leurs points de fonctionnement optimaux respectifs.

L'idée qui est à la base de l'invention est alors de dissocier thermiquement les composants électroniques du circuit de découpage de puissance vis-à-vis des condensateurs électrolytiques du circuit de filtrage, et de dissocier les moyens de refroidissement respectifs des composants électroniques et des condensateurs électrolytiques, en minimisant l'impact sur le flux d'air utile du ventilateur.

Ainsi, pour atteindre ces buts ainsi que d'autres, l'invention propose un dispositif de commande pour moteur électrique de ventilation d'échangeur d'automobile, comprenant :
- un circuit électronique de puissance, ayant une entrée de puissance destinée à être connectée à une source d'alimentation électrique à courant continu, ayant une sortie de puissance destinée à être connectée au moteur électrique de ventilation d'échangeur, ayant au moins un transistor à effet de champ à grille isolée dont le circuit source-drain est connecté entre l'entrée de puissance et la sortie de puissance pour être en série avec le moteur électrique de ventilation d'échangeur, et ayant au moins une diode de roue libre connectée en polarisation inverse sur la sortie de puissance pour permettre la circulation du courant généré par la composante inductive du moteur électrique de ventilation d'échangeur lorsque le transistor à effet de champ à grille isolée est bloqué,
- un circuit de filtrage, connecté à l'entrée de puissance pour réduire l'amplitude des composantes à haute fréquence des courants et tensions générés par la composante inductive du moteur électrique de ventilation d'échangeur lors du blocage du transistor à effet de champ à grille isolée, et comportant un ou plusieurs condensateurs électrolytiques,

- une commande de commutation, apte à générer sur la grille du transistor à effet de champ à grille isolée un signal de commande carré modulé en largeur,
- un boîtier contenant au moins le circuit électronique de puissance et le circuit de filtrage ;
selon l'invention :
- le boîtier comprend au moins un compartiment ventilé, à première cavité intérieure limitée par une première paroi périphérique munie d'ouvertures pour autoriser le passage, dans la première cavité intérieure, d'un flux d'air provenant de l'extérieur du boîtier,
- le boîtier comprend au moins un compartiment isolé, à seconde cavité intérieure limitée par une seconde paroi périphérique et séparée du compartiment ventilé par au moins une paroi d'isolation thermique,
- le ou les transistors à effet de champ à grille isolée et la ou les diodes de roue libre sont disposés dans la seconde cavité intérieure du compartiment isolé,
   le ou les condensateurs électrolytiques sont disposés dans la première cavité intérieure du compartiment ventilé.

Grâce à cette disposition, les condensateurs électrolytiques, qui doivent travailler à des températures relativement basses, sont thermiquement isolés des composants électroniques tels que les diodes et les transistors à effet de champ à grille isolée qui génèrent des calories, et ils sont simultanément refroidis par le flux d'air traversant le compartiment ventilé. On peut ainsi maintenir leur température à des valeurs nettement inférieures à 100°C, de sorte que leur durée de vie est maximisée.

A l'inverse, les composants électroniques tels que les diodes et les transistors à effet de champ à grille isolée, qui de préférence travaillent à des températures relativement hautes de l'ordre de 150°C, n'ont pas besoin d'être refroidis par le flux d'air du ventilateur, de sorte qu'il n'y a pas besoin de placer dans le flux d'air du ventilateur le compartiment isolé dans lequel ils sont contenus, et le flux d'air du ventilateur n'est ainsi affecté que par le seul compartiment ventilé, dont le volume est réduit et qui induit donc une perte de charge minimale.

On réalise ainsi un dispositif de commande qui satisfait les besoins mentionnés ci-dessus.

Selon un mode de réalisation avantageux, le ou les transistors à effet de champ à grille isolée et la ou les diodes de roue libre ont leurs boîtiers respectifs couplés thermiquement à un conducteur de sortie destiné à assurer la connexion électrique avec le moteur électrique de ventilation d'échangeur. De la sorte, les composants électroniques tels que les diodes et les transistors à effet de champ à grille isolée, qui de préférence travaillent à des températures relativement hautes de l'ordre de 150°C, sont suffisamment refroidis par conduction thermique par le conducteur électrique de sortie auquel ils sont couplés thermiquement. Ce refroidissement est encore amélioré si on fait en sorte que les conducteurs de sortie traversent le flux d'air de ventilation d'échangeur entre le dispositif de commande et le moteur électrique de ventilation.

En pratique, ledit conducteur de sortie peut comporter un premier tronçon en forme de plaque métallique sur laquelle sont fixés les boîtiers respectifs du ou des transistors à effet de champ à grille isolée et les boîtiers respectifs de la ou des diodes de roue libre. On optimise ainsi le couplage thermique entre les composants électroniques et le conducteur de sortie chargé d'évacuer l'excès de calories qu'ils produisent.

Les condensateurs électrolytiques sont des composants très sensibles aux agressions mécaniques. Il est donc impératif de les protéger. Cette protection est en principe assurée par la première paroi périphérique du compartiment ventilé. Simultanément, la première paroi périphérique du compartiment ventilé doit permettre le passage d'un flux d'air de refroidissement, pour assurer le maintien d'une température basse de fonctionnement des condensateurs électrolytiques. Ces deux exigences sont contradictoires, car la protection mécanique nécessiterait une fermeture totale de la première paroi périphérique, tandis que le passage d'un flux d'air nécessiterait une ouverture totale de la première paroi périphérique. Un bon compromis peut être obtenu en prévoyant que la première paroi périphérique comporte deux grandes ouvertures opposées l'une à l'autre, et comporte, à l'opposé de la paroi d'isolation thermique, une grille en matière plastique.

Les condensateurs électrolytiques sont également des composants très sensibles aux agressions physico-chimiques. Il est donc impératif de les protéger également contre ce type d'agression. Pour cela, on peut avantageusement prévoir que le ou les condensateurs électrolytiques sont chacun enveloppés dans une gaine protectrice respective.

En pratique, les condensateurs électrolytiques ont habituellement une forme générale cylindrique, ayant deux faces d'extrémité opposées relativement planes et parallèles, et ayant une face latérale périphérique cylindrique. Dans ce cas, la gaine protectrice respective peut être tubulaire et peut entourer de façon étanche la face latérale périphérique du condensateur. Les extrémités du condensateur peuvent avantageusement être noyées dans une résine étanche, qui assure simultanément la fermeture de la gaine protectrice. Le condensateur électrolytique est ainsi complètement isolé de l'atmosphère extérieure.

La gaine protectrice respective peut avantageusement être en une matière plastique thermo-rétractable, et être au contact de la face latérale périphérique du condensateur. De la sorte, la gaine protectrice assure la protection physico-chimique de la paroi latérale périphérique cylindrique du condensateur, sans affecter sensiblement son refroidissement par le flux d'air qui traverse le compartiment ventilé.

Selon un autre aspect, l'invention propose d'appliquer le dispositif de commande ci-dessus à la commande du moteur électrique actionnant le ventilateur d'échangeur thermique dans un véhicule automobile. On prévoit ainsi un véhicule automobile à échangeur thermique et ventilateur actionné par un moteur électrique à courant continu pour ventiler l'échangeur thermique, dans lequel le moteur électrique est commandé par un dispositif de commande tel que défini ci-dessus.

En général, le ventilateur est raccordé à l'échangeur thermique par une gaine de confinement de flux d'air, de sorte que tout l'air mis en mouvement par le ventilateur traverse l'échangeur thermique. Dans ce cas, le boîtier du dispositif de commande peut avantageusement être disposé en périphérie dans la gaine de confinement de flux d'air, avec le compartiment ventilé positionné de façon à être traversé par le flux d'air généré par le ventilateur, tandis que le compartiment isolé peut être placé à l'écart du flux d'air pour éviter de le perturber.

D'autres objets, caractéristiques et avantages de la présente invention ressortiront de la description suivante de modes de réalisation particuliers, faite en relation avec les figures jointes, parmi lesquelles :
- la figure 1 est le schéma électrique de principe d'un circuit électronique de commande à découpage de tension à modulation de largeur selon un mode de réalisation de la présente invention ;
- la figure 2 est une vue en perspective d'un dispositif de commande selon un mode de réalisation de la présente invention, incorporant, dans un boîtier de protection, le circuit électronique de la figure 1 ;
- la figure 3 illustre, en perspective, le circuit électronique de commande de la figure 2, en occultant les parois du boîtier ;
- la figure 4 est une vue en perspective éclatée du dispositif de la figure 2 ;
- la figure 5 est une autre vue en perspective éclatée du dispositif de la figure 2, en occultant certaines parois du boîtier ;
- la figure 6 est similaire de la figure 5, selon un autre angle de vue ; et
- la figure 7 illustre l'implantation du dispositif de commande selon la présente invention dans une gaine de confinement du flux d'air d'un ventilateur d'échangeur d'automobile.

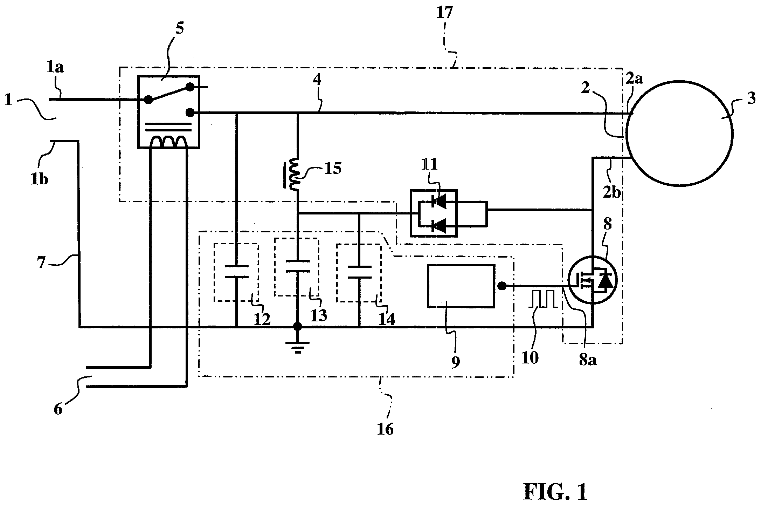

Dans le mode de réalisation de la figure 1, le circuit électronique de commande à découpage de tension à modulation de largeur se développe entre une entrée de puissance 1 destinée à être connectée à une source d'alimentation électrique à courant continu telle que la batterie d'accumulateurs d'un véhicule automobile, et une sortie de puissance 2 destinée à être connectée au moteur électrique 3 de ventilation d'échangeur du véhicule automobile.

La borne positive 1a de l'entrée de puissance 1 est raccordée à la borne positive 2a de la sortie de puissance 2 par un premier conducteur principal 4 comportant, en série, le contact de puissance d'un relais 5 dont la commutation et pilotée sur une entrée de validation 6. L'ouverture du contact de puissance du relais 5 interrompt l'alimentation du moteur 3, tandis que la fermeture du contact de puissance du relais 5 autorise l'alimentation du moteur 3.

La borne négative 1b de l'entrée de puissance 1 est raccordé à la borne négative 2b de la sortie de puissance 2 par un second conducteur principal 7 comportant, en série, le circuit drain-source d'un transistor à effet de champ à grille isolée 8 dont la grille 8a est connectée à la sortie d'une commande de commutation 9 apte à produire un signal de commande 10 de forme carrée à modulation de largeur.

La borne négative 2b et la borne positive 2a de la sortie de puissance 2 sont en outre raccordées l'une à l'autre par une diode de roue libre 11 connectée en polarisation inverse.

Ainsi, le premier conducteur principal 4, le second conducteur principal 7, le relais 5, le transistor à effet de champ à grille isolée 8 et la diode de roue libre 11 constituent ensemble le circuit électronique de puissance. La mise en conduction du transistor à effet de champ à grille isolée 8 permet d'amener aux bornes du moteur 3 la tension d'alimentation présente sur l'entrée de puissance 1 pour un fonctionnement du moteur 3 à pleine vitesse. Le blocage du transistor à effet de champ à grille isolée 8 permet d'interrompre totalement l'alimentation du moteur 3. Et l'application d'un signal de commande 10 carré à modulation de largeur sur la grille 8a du transistor à effet de champ à grille isolée 8 permet de produire, sur les bornes du moteur 3, une tension d'alimentation découpée à modulation de largeur dans laquelle la tension d'alimentation est tantôt égale à la tension d'entrée pendant des étapes de conduction du transistor à effet de champ à grille isolée 8 et tantôt égale à zéro pendant des étapes de non-conduction du transistor à effet de champ à grille isolée 8. La diode de roue libre 11 permet la circulation du courant généré par la composante inductive du moteur 3 lorsque le transistor à effet de champ à grille isolée 8 commute vers son état bloqué.

Un premier condensateur électrolytique 12 est connecté entre le second conducteur principal 7 et le premier conducteur principal 4 en sortie du contact de puissance du relais 5. Un second condensateur électrolytique 13 et un troisième condensateur électrolytique 14 sont connectés tous deux en parallèle entre le second conducteur principal 7 et la cathode de la diode de roue libre 11 elle-même connectée au premier conducteur principal 4 en sortie du contact de puissance du relais 5 par l'intermédiaire d'un élément inductif 15.

Les condensateurs électrolytiques 12, 13 et 14 constituent, avec l'élément inductif 15, un circuit de filtrage permettant de réduire l'amplitude des composantes à haute fréquence des courants et tensions générées lors des commutations du transistor à effet de champ à grille isolée 8 dans le circuit électronique de puissance.

Les composants du circuit électronique illustré sur la figure 1 sont logés dans un boîtier comprenant deux compartiments distincts, à savoir un compartiment ventilé 16 illustré schématiquement en traits mixtes sur la figure 1, et un compartiment isolé 17 également illustré schématiquement en traits mixtes sur la figure 1. Le compartiment ventilé 16 contient essentiellement les condensateurs électrolytiques 12, 13 et 14, qui nécessitent de travailler à faible température. Le compartiment isolé 17 contient les autres éléments du circuit électronique de puissance, à savoir le transistor à effet de champ à grille isolée 8, la diode de roue libre 11 et le relais 5.

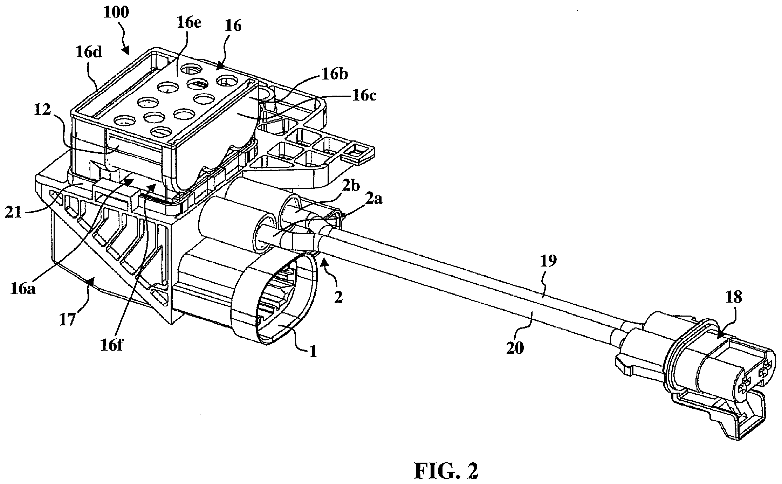

On considère maintenant la figure 2, qui illustre en perspective un dispositif de commande selon l'invention dans lequel le circuit électronique schématisé sur la figure 1 est incorporé dans un boîtier 100. On retrouve, sur cette figure 2, le compartiment ventilé 16 du boîtier 100, dans lequel on distingue le condensateur électrolytique 12. On retrouve également, sur cette figure 2, le compartiment isolé 17 avec son entrée de puissance 1 et les deux bornes 2a et 2b de sa sortie de puissance 2. La sortie de puissance 2 est raccordée électriquement au moteur 3 par un connecteur de sortie 18 et par deux conducteurs de sortie 19 et 20 souples et isolés électriquement.

Le compartiment ventilé 16 et le compartiment isolé 17 sont séparés l'un de l'autre par une paroi d'isolation thermique 21. Le compartiment ventilé 16 comprend une première cavité intérieure 16a limitée par une première paroi périphérique 16b munie d'ouvertures pour autoriser le passage d'un flux d'air provenant de l'extérieur du boîtier 100. En pratique, la première paroi périphérique 16b comporte deux flasques opposés pleins 16c et 16d, une grille en matière plastique 16e opposée à la paroi d'isolation thermique 21, et deux grandes ouvertures opposées l'une à l'autre telles que l'ouverture 16f visible sur la figure 2.

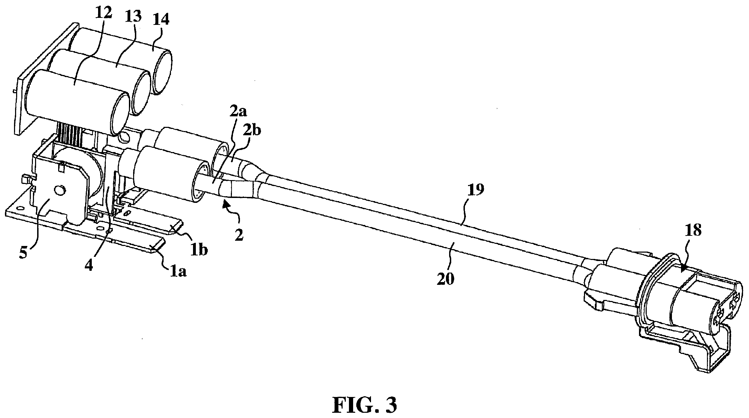

Sur la figure 3, on a ôté les parois du boîtier 100 pour mieux distinguer les composants du circuit électronique. On retrouve ainsi le relais 5, le premier conducteur principal 4, les bornes d'entrée de puissance 1a et 1b, les bornes de sortie de puissance 2a et 2b, les conducteurs de sortie 19 et 20, le connecteur de sortie 18, et les trois condensateurs électrolytiques 12, 13 et 14.

Le relais 5 est connecté électriquement, et donc couplé thermiquement, au conducteur principal 4 lui-même connecté et couplé thermiquement au conducteur de sortie 20.

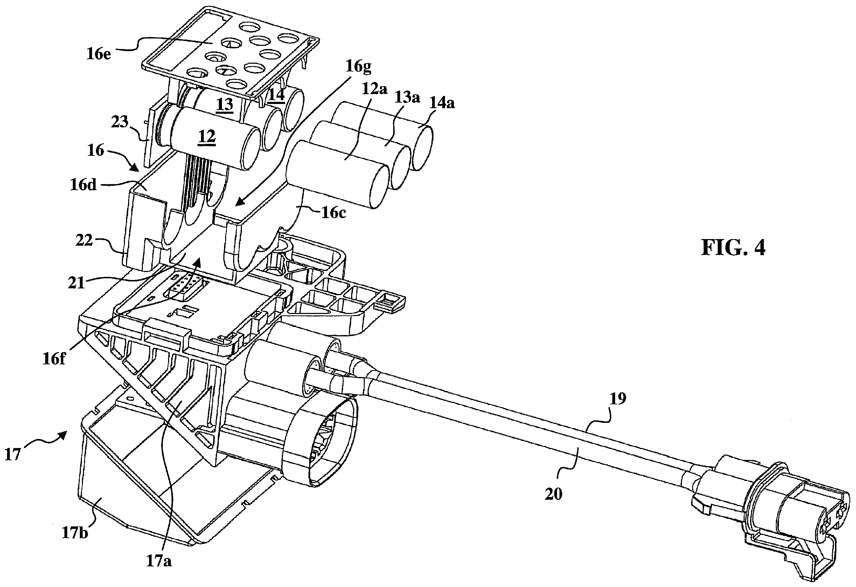

Sur la figure 4, on a illustré le dispositif de la figure 2 sous forme éclatée. Dans ce mode de réalisation, le compartiment ventilé 16 comprend une platine support 22, dont une face inférieure constitue la paroi d'isolation thermique 21, dont deux faces opposées forment les flasques 16c et 16d, et dont deux côtés sont largement ouverts pour former les grandes ouvertures opposées l'une à l'autre 16f et 16g. Le compartiment ventilé 16 comprend en outre la grille en matière plastique 16e, opposée à la paroi d'isolation thermique 21. Le compartiment ventilé 16 contient les trois condensateurs électrolytiques 12, 13 et 14, rassemblés et connectés sur un circuit imprimé 23.

Chacun des condensateurs électrolytiques 12, 13 et 14 reçoit une gaine tubulaire de protection respective 12a, 13a et 14a, en matière plastique thermo-rétractable venant en contact de la paroi latérale périphérique du condensateur électrolytique respectif. En pratique, la gaine tubulaire de protection peut être réalisée par rétractation d'une gaine habituellement utilisée pour l'isolation des conducteurs électriques. Son épaisseur est choisie relativement faible, juste suffisante pour assurer une protection du condensateur électrolytique contre les agressions chimiques présentes dans l'air de ventilation ambiant, et suffisamment mince pour ne pas perturber le refroidissement du condensateur électrolytique par l'air de ventilation ambiant.

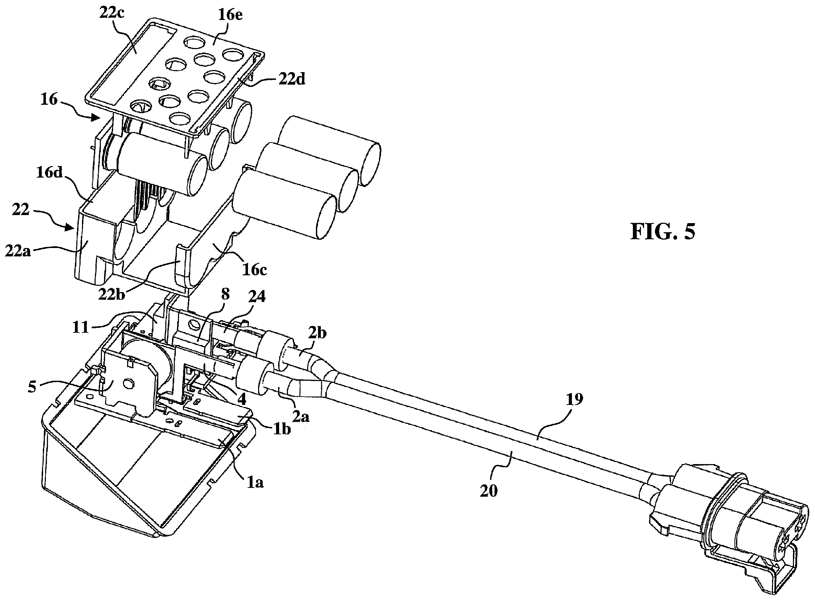

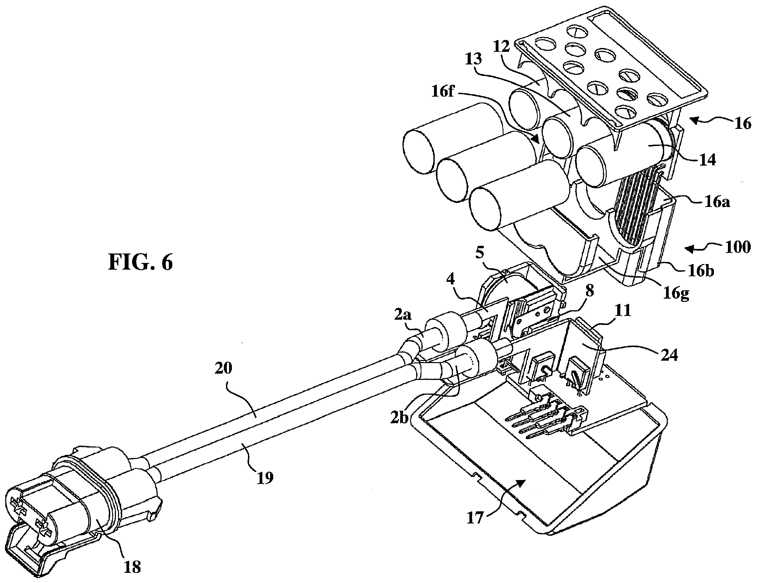

Le compartiment isolé 17 est formé de l'assemblage d'un corps de compartiment 17a et d'un capot inférieur 17b. On considère ensuite les figures 5 et 6, pour distinguer les composants à l'intérieur du compartiment isolé 17. Sur la figure 5, on distingue à nouveau le relais 5, les bornes d'entrée de puissance 1a et 1b, et le premier conducteur principal 4 connecté entre le relais 5 et la borne positive 2a de sortie de puissance. On distingue en outre le transistor à effet de champ à grille isolée 8 et la diode de roue libre 11, tous deux connectés électriquement à la borne négative 2b de sortie de puissance.

Comme on le voit mieux sur la figure 6, le transistor à effet de champ à grille isolée 8 et la diode de roue libre 11 ont leurs boîtiers respectifs couplés thermiquement à un conducteur de sortie 19 destiné à assurer simultanément la connexion électrique avec le moteur électrique de ventilation d'échangeur. Ce conducteur de sortie 19 comporte un premier tronçon 24 de conducteur en forme de plaque métallique coudée à angle droit et raccordée par la borne négative 2b de sortie de puissance à un second tronçon de conducteur lui-même connecté au moteur par le connecteur de sortie 18. Le boîtier respectif du transistor à effet de champ à grille isolée 8 et le boîtier respectif de la diode de roue libre 11 sont tous deux fixés sur la plaque métallique formant le premier tronçon 24 du conducteur de sortie 19.

Dans la réalisation illustrée sur les figures, les condensateurs électrolytiques 12, 13 et 14 ont chacun une forme générale cylindrique ayant deux extrémités planes parallèles l'une à l'autre et ayant une face latérale périphérique cylindrique. Lorsque les condensateurs électrolytiques sont en position dans le compartiment ventilé 16, les gaines protectrices respectives 12a, 13a et 14a entourent de façon étanche la face latérale périphérique de chaque condensateur électrolytique respectif, et les extrémités de chaque condensateur électrolytique sont noyées dans une résine étanche qui assure simultanément la fermeture de la gaine protectrice respective.

En pratique, la platine support 22 forme, avec la grille supérieure 16e, des compartiments de coulée de résine fermés vers l'extérieur par les flasques 16c et 16d, fermés vers l'intérieur par des arceaux venant s'adapter contre la face périphérique du condensateur, fermés sur les côtés par des facettes 22a et 22b, et ouverts sur le dessus par des ouvertures 22c et 22d. Après adaptation des condensateurs électrolytiques et fermeture du compartiment ventilé 16, on coule une résine par les ouvertures 22c et 22d pour fermer les gaines de protection et assurer une protection efficace des condensateurs électrolytiques.

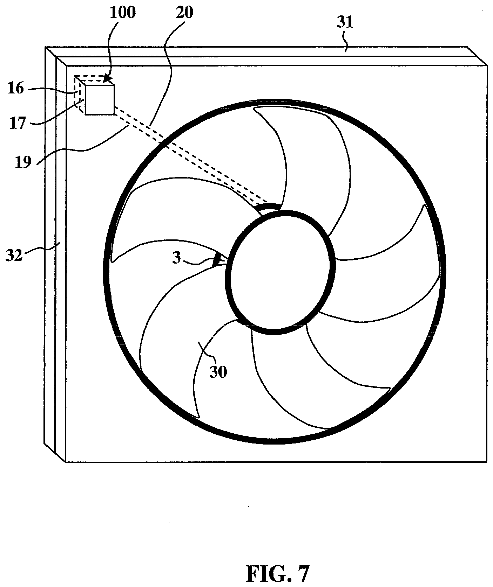

On considère maintenant la figure 7, illustrant schématiquement le positionnement du dispositif de commande selon l'invention dans un véhicule automobile.

Le ventilateur 30, entraîné par le moteur 3, est positionné en regard d'un échangeur thermique 31 auquel il est relié par une gaine de confinement de flux d'air 32. Le boîtier 100 du dispositif de commande est disposé en périphérie dans la gaine de confinement de flux d'air 32. Son compartiment ventilé 16 est placé à l'intérieur de la gaine de confinement de flux d'air 32 de façon à être traversé par un flux d'air généré par le ventilateur 30. Son compartiment isolé 17 peut avantageusement être positionné à l'écart du flux d'air généré par le ventilateur 30.

Par contre, les conducteurs de sortie 19 et 20 traversent et sont refroidis par le flux d'air généré par le ventilateur 30, ce qui participe au refroidissement des composants électroniques et du relais 5 avec lesquels les conducteurs 19 et 20 sont couplés thermiquement.

La présente invention n'est pas limitée aux modes de réalisation qui ont été explicitement décrits, mais elle en inclut les diverses variantes et généralisations contenues dans le domaine des revendications ci-après.

## Revendications

1. Dispositif de commande pour moteur électrique (3) de ventilation d'échangeur d'automobile, comprenant :
- un circuit électronique de puissance, ayant une entrée de puissance (1) destinée à être connectée à une source d'alimentation électrique à courant continu, ayant une sortie de puissance (2) destinée à être connectée au moteur électrique (3) de ventilation d'échangeur, ayant au moins un transistor à effet de champ à grille isolée (8) dont le circuit source-drain est connecté entre l'entrée de puissance (1) et la sortie de puissance (2) pour être en série avec le moteur électrique (3) de ventilation d'échangeur, et ayant au moins une diode de roue libre (11) connectée en polarisation inverse sur la sortie de puissance (2) pour permettre la circulation du courant généré par la composante inductive du moteur électrique (3) de ventilation d'échangeur lorsque le transistor à effet de champ à grille isolée (8) est bloqué,
- un circuit de filtrage, connecté à l'entrée de puissance (1) pour réduire l'amplitude des composantes à haute fréquence des courants et tensions générés par la composante inductive du moteur électrique (3) de ventilation d'échangeur lors du blocage du transistor à effet de champ à grille isolée (8), et comportant un ou plusieurs condensateurs électrolytiques (12, 13, 14),
- une commande de commutation (9), apte à générer sur la grille (8a) du transistor à effet de champ à grille isolée (8) un signal de commande (10) carré modulé en largeur,
- un boîtier (100) contenant au moins le circuit électronique de puissance et le circuit de filtrage,
**caractérisé en ce que** :
- le boîtier (100) comprend au moins un compartiment ventilé (16), à première cavité intérieure (16a) limitée par une première paroi périphérique (16b) munie d'ouvertures (16f, 16g) pour autoriser le passage, dans la première cavité intérieure (16a), d'un flux d'air provenant de l'extérieur du boîtier (100),
- le boîtier (100) comprend au moins un compartiment isolé (17), à seconde cavité intérieure limitée par une seconde paroi périphérique et séparée du compartiment ventilé (16) par au moins une paroi d'isolation thermique (21),
- le ou les transistors à effet de champ à grille isolée (8) et la ou les diodes de roue libre (11) sont disposés dans la seconde cavité intérieure du compartiment isolé (17),
- le ou les condensateurs électrolytiques (12, 13, 14) sont disposés dans la première cavité intérieure (16a) du compartiment ventilé (16).

2. Dispositif selon la revendication 1, **caractérisé en ce que** le ou les transistors à effet de champ à grille isolée (8) et la ou les diodes de roue libre (11) ont leurs boîtiers respectifs couplés thermiquement à un conducteur de sortie (19) destiné à assurer la connexion électrique avec le moteur électrique (3) de ventilation d'échangeur.

3. Dispositif selon la revendication 2, **caractérisé en ce que** ledit conducteur de sortie (19) comporte un premier tronçon (24) de conducteur en forme de plaque métallique sur laquelle sont fixés les boîtiers respectifs du ou des transistors à effet de champ à grille isolée (8) et les boîtiers respectifs de la ou des diodes de roue libre (11).

4. Dispositif selon l'une quelconque des revendications 1 à 3, **caractérisé en ce que** la première paroi périphérique (16b) comporte deux grandes ouvertures (16f, 16g) opposées l'une à l'autre, et comporte, à l'opposé de la paroi d'isolation thermique (21), une grille en matière plastique (16e).

5. Dispositif selon l'une quelconque des revendications 1 à 4, **caractérisé en ce que** le ou les condensateurs électrolytiques (12, 13, 14) sont chacun enveloppés dans une gaine protectrice respective (12a, 13a, 14a).

6. Dispositif selon la revendication 5, **caractérisé en ce que** chaque condensateur électrolytique (12, 13, 14) est de forme générale cylindrique ayant deux extrémités et une face latérale périphérique cylindrique, la gaine protectrice respective (12a, 13a, 14a) est tubulaire et entoure de façon étanche la face latérale périphérique du condensateur, et les extrémités du condensateur sont noyées dans une résine étanche.

7. Dispositif selon l'une des revendications 5 ou 6, **caractérisé en ce que** la gaine protectrice respective (12a, 13a, 14a) est en matière plastique thermo-rétractable et est au contact de la face latérale périphérique du condensateur.

8. Véhicule automobile à échangeur thermique (31) et ventilateur (30) actionné par un moteur électrique (3) pour ventiler l'échangeur thermique (31), **caractérisé en ce que** le moteur électrique (3) est commandé par un dispositif de commande selon l'une quelconque des revendications 1 à 7.

9. Véhicule selon la revendication 8, **caractérisé en ce que** :
- le ventilateur (30) est raccordé à l'échangeur thermique (31) par une gaine de confinement de flux d'air (32),
- le boîtier (100) du dispositif de commande est disposé en périphérie dans la gaine de confinement de flux d'air (32), avec le compartiment ventilé (16) positionné de façon à être traversé par le flux d'air généré par le ventilateur (30).

## Patentansprüche

1. Steuervorrichtung für einen Elektromotor (3) zur Wärmetauscherventilation in einem Automobil, umfassend:
- eine elektrische Leistungsschaltung aufweisend einen Leistungseingang (1), welcher dazu vorgesehen ist, mit einer elektrischen Gleichstromquelle zur Speisung verbunden zu werden, aufweisend einen Leistungsausgang (2), welcher dazu vorgesehen ist, an den Elektromotor (3) zur Wärmetauscherventilation angeschlossen zu werden, aufweisend wenigstens einen Feldeffekttransistor mit isolierter Gateelektrode (8), bei dem die die Source-Drain-Schaltung zwischen dem Leistungseingang (1) und dem Leistungsausgang (2) verbunden ist, um in Reihe mit dem dem Elektromotor (3) zur Wärmetauscherventilation zu sein, und aufweisend wenigstens eine Freilaufdiode (11), die in Sperrrichtung mit dem Leistungsausgang (2) verbunden ist, um den Fluss eines Stromes zuzulassen, der durch eine induktive Komponente des Elektromotors (3) zur Wärmetauscherventilation generiert wird, wenn der Feldeffekttransistor mit isolierter Gateelektrode (8) gesperrt ist,
- eine Filterschaltung, die an den Leistungseingang (1) zur Dämpfung der Amplitude hochfrequenter Strom- und Spannungskomponenten angeschlossen ist, die durch während der Sperrung des Feldeffekttransistor mit isolierter Gateelektrode (8) durch die induktive Komponente des Elektromotors (3) zur Wärmetauscherventilation generiert werden, und die einen oder mehrere Elektrolytkondensator (12, 13, 14) umfasst,
- eine Steuerschaltung (9), die eingerichtet ist, an das Gate (8a) des Feldeffekttransistors mit isolierter Gateelektrode (8) ein in der Breite rechteckteckig moduliertes Steuersignal (10) anzulegen,
- ein Gehäuse (100), welches wenigstens die elektronische Leistungsschaltung und die Filterschaltung enthält,
**dadurch gekennzeichnet, dass**:
- das Gehäuse (100) wenigstens ein belüftetes Fach (16) mit einem ersten Innenraum (16a) enthält, der über eine erste Außenwand (16b) begrenzt ist, die Öffnungen (16f, 16g) besitzt, um die Durchleitung eines Luftstromes durch den ersten Innenraum (16a) zuzulassen, der von der Außenseite des Gehäuses (100) kommt,
- das Gehäuse (100) wenigstens ein isoliertes Fach (17) mit einem zweiten Innenraum enthält, der über eine zweite Außenwand begrenzt und der gegenüber dem belüfteten Fach (16) über wenigstens eine thermische Isolationswand (21) abgegrenzt ist,
- der oder die Feldeffekttransistor/-en mit isolierter Gateelektrode (8) und die Freilaufdiode/-n (11) im zweiten Innenraum des isolierten Faches (17) angeordnet sind,
- der oder die Elektrolytkondensator/-en (12, 13, 14) im ersten Innenraum (16a) des belüfteten Faches (16) angeordnet sind.

2. Vorrichtung nach Anspruch 1, **dadurch gekennzeichnet, dass** der oder die Feldeffekttransistor/-en mit isolierter Gateelektrode (8) und die Freilaufdiode/-n (11) ihre jeweiligen Kammern besitzen, die thermisch an einen Ausgangsleiter (19) angeschlossen sind, welcher vorgesehen ist, die elektrische Verbindung mit dem Elektromotor (3) zur Wärmetauscherventilation sicherzustellen.

3. Vorrichtung nach Anspruch 2, **dadurch gekennzeichnet, dass** der genannte Ausgangsleiter (19) einen ersten Leiterabschnitt (24) in Form einer Metallplatte auf der die entsprechenden Kammern des oder der Feldeffekttransistor/-en mit isolierter Gateelektrode (8) und die entsprechenden Kammern der Freilaufdiode/-n (11) befestigt sind.

4. Vorrichtung nach einem der Ansprüche 1 bis 3, **dadurch gekennzeichnet, dass** die erste Außenwand (16b) zwei sich gegenüberliegende große Öffnungen (16f, 16g) und gegenüberliegend zur thermischen Isolationswand (21) ein Gitter aus plastischem Material (16e) umfasst.

5. Vorrichtung nach einem der Ansprüche 1 bis 4, **dadurch gekennzeichnet, dass** der oder die Elektrolytkondensator/-en (12, 13, 14) jeder in einer entsprechenden Schutzhülle (12a, 13a, 14a) eingehaust sind.

6. Vorrichtung nach Anspruch 5, **dadurch gekennzeichnet, dass** jeder Elektrolytkondensator (12, 13, 14) im Wesentlichen zylindrisch mit zwei Enden und einer Mantelseite ausgebildet ist, wobei die Schutzhülle (12a, 13a, 14a) röhrenförmig ist und die Mantelseite der Kondensatoren in einer wasserdichten Weise umgibt, und die die Enden des Kondensators in einer wasserdichten Harz getränkt sind.

7. Vorrichtung nach Ansprüche 5 oder 6, **dadurch gekennzeichnet, dass** die entsprechende Schutzhülle (12a, 13a, 14a) aus einem thermoschrumpffähigen plastischen Material ist und im Kontakt mit der Mantelseite des Kondensators steht.

8. Fahrzeug mit einem Wärmetauscher (31) und einem durch einen Elektromotor (3) angetriebenen Ventilator (30) zur Ventilation des Wärmetauschers (31), **dadurch gekennzeichnet, dass** der elektrische Motor (3) durch eine Steuervorrichtung nach einem der Ansprüche 1 bis 7 gesteuert ist.

9. Fahrzeug nach Anspruch 8, **dadurch gekennzeichnet, dass**:
- der Ventilator (30) an den Wärmetauscher (31) über einen gesicherten Luftströmungskanal (32) angebunden ist,
- das Gehäuse (100) der Steuervorrichtung randseitig im gesicherten Luftströmungskanal (32) mit dem belüftetes Fach (16) in derart angeordnet ist, dass sie quer zum Luftstrom stehen, der durch den Ventilator (30) erzeugt wird.

## Claims

1. Control device for a motor-vehicle exchanger fan electric motor (3), said device comprising:
- a power electronic circuit having a power input (1) that is intended to be connected to a DC electrical power source, having a power output (2) that is intended to be connected to the exchanger fan electric motor (3), having at least one insulated-gate field-effect transistor (8) the source-drain circuit of which is connected between the power input (1) and the power output (2) in order to be in series with the exchanger fan electric motor (3), and having at least one flyback diode (11) that is connected in reverse bias to the power output (2) in order to allow the current generated by the inductive component of the exchanger fan electric motor (3) to flow when the insulated-gate field-effect transistor (8) is turned off;
- a filtering circuit that is connected to the power input (1), in order to decrease the amplitude of the high-frequency components of the currents and voltages generated by the inductive component of the exchanger fan electric motor (3) during the turn-off of the insulated-gate field-effect transistor (8), and that includes one or more electrolytic capacitors (12, 13, 14) ;
- a switching control unit (9) that is able to generate, on the gate (8a) of the insulated-gate field-effect transistor (8), a width-modulated square-wave control signal (10); and
- a housing (100) containing at least the power electronic circuit and the filtering circuit; **characterized in that**:
- the housing (100) comprises at least one ventilated compartment (16) that contains a first interior cavity (16a) that is bounded by a first peripheral wall (16b) that is equipped with apertures (16f, 16g) in order to permit the passage, into the first interior cavity (16a), of an air flow originating from outside the housing (100);
- the housing (100) comprises at least one isolated compartment (17) that contains a second interior cavity that is bounded by a second peripheral wall and that is separated from the ventilated compartment (16) by at least one thermally insulating wall (21);
- the one or more insulated-gate field-effect transistors (8) and the one or more flyback diodes (11) are placed in the second interior cavity of the isolated compartment (17); and
- the one or more electrolytic capacitors (12, 13, 14) are placed in the first interior cavity (16a) of the ventilated compartment (16).

2. Device according to Claim 1, **characterized in that** the one or more insulated-gate field-effect transistors (8) and the one or more flyback diodes (11) have their respective packages thermally coupled to an output conductor (19) that is intended to ensure the electrical connection with the exchanger fan electric motor (3).

3. Device according to Claim 2, **characterized in that** said output conductor (19) includes a first conductor section (24) taking the form of a metal sheet to which the respective packages of the one or more insulated-gate field-effect transistors (8) and the respective packages of the one or more flyback diodes (11) are fastened.

4. Device according to any one of Claims 1 to 3, **characterized in that** the first peripheral wall (16b) includes two large apertures (16f, 16g) that are opposite each other, and includes, opposite the thermally insulating wall (21), a plastic grid (16e).

5. Device according to any one of Claims 1 to 4, **characterized in that** the one or more electrolytic capacitors (12, 13, 14) are each enveloped in a respective protective sheath (12a, 13a, 14a).

6. Device according to Claim 5, **characterized in that** each electrolytic capacitor (12, 13, 14) is of generally cylindrical shape and has two ends and a cylindrical peripheral lateral face, the respective protective sheath (12a, 13a, 14a) is tubular and seal-tightly encircles the peripheral lateral face of the capacitor, and the ends of the capacitor are embedded in a seal-tight resin.

7. Device according to either of Claims 5 and 6, **characterized in that** the respective protective sheath (12a, 13a, 14a) is made of a heat-shrinkable plastic and makes contact with the peripheral lateral face of the capacitor.

8. Motor vehicle comprising a heat exchanger (31) and a fan (30) that is actuated by an electric motor (3) in order to blow air over the heat exchanger (31), **characterized in that** the electric motor (3) is controlled by a control device according to any one of Claims 1 to 7.

9. Vehicle according to Claim 8, **characterized in that**:
- the fan (30) is connected to the heat exchanger (31) by an air-flow-confining duct (32); and
- the housing (100) of the control device is placed peripherally in the air-flow-confining duct (32), with the ventilated compartment (16) positioned so as to be passed through by the air flow generated by the fan (30) .
